# EUROPEAN PATENT SPECIFICATION

(11) **EP 4 098 958 B1**
(45) Date of publication and mention of the grant of the patent: **23.10.2024**
(21) Application number: 21757869.9
(22) Date of filing: 09.02.2021
(51) Int. Cl.: F25D 11/02, H05K 7/20

(54) **CONTROL METHOD FOR HEATING UNIT, AND REFRIGERATING AND FREEZING APPARATUS**
STEUERUNGSVERFAHREN FÜR HEIZEINHEIT SOWIE KÜHL- UND GEFRIERGERÄT
PROCÉDÉ DE COMMANDE POUR UNITÉ DE CHAUFFAGE, ET APPAREIL DE RÉFRIGÉRATION ET DE CONGÉLATION

(30) Priority: 18.02.2020 CN 202010099918; 18.02.2020 CN 202020180615 U
(43) Date of publication of application: 07.12.2022
(73) Proprietor: Qingdao Haier Refrigerator Co., Ltd., Laoshan District Qingdao Shandong 266101 (CN); Haier Smart Home Co., Ltd., Qingdao, Shandong 266101 (CN)
(72) Inventor: QI, Feifei, Qingdao, Shandong 266101 (CN); SONG, Xiangpeng, Qingdao, Shandong 266101 (CN); CUI, Zhanpeng, Qingdao, Shandong 266101 (CN); HAN, Zhiqiang, Qingdao, Shandong 266101 (CN); XUE, Wenchao, Qingdao, Shandong 266101 (CN)
(74) Representative: Ziebig Hengelhaupt Intellectual Property Attorneys Patentanwaltskanzlei PartGmbB
(86) International application number: PCT/CN2021/076240
(87) International publication number: WO 2021/164648

(56) References cited:
- CN-A- 103 428 931
- CN-A- 103 428 931
- CN-A- 106 016 391
- CN-C- 1 168 925
- CN-U- 209 893 723
- CN-U- 209 893 724
- CN-U- 209 893 783
- CN-U- 209 897 305
- CN-U- 211 823 376
- CN-U- 212 211 435
- JP-A- 2018 141 625
- US-B2- 10 064 247

## Description

### FIELD OF THE INVENTION

The present disclosure relates to the field of food processing, and in particular to a control method for a heating unit, and a refrigerating and freezing apparatus

### BACKGROUND OF THE INVENTION

During the freezing process of food, the quality of food is maintained. However, the frozen food needs to be heated before processing or eating. In order to facilitate a user freezing and heating food, in the prior art, food is generally thawed by providing an electromagnetic wave heating unit in a refrigerating and freezing apparatus such as a refrigerator.

For instance, US 10 064 247 B2 discloses a microwave heating apparatus and methods of controlling cooling of a microwave heating apparatus. The microwave heating apparatus typically includes a microwave source for generating microwaves, a cooling unit for cooling the microwave source and a control unit. According to one embodiment, the control unit is configured to determine the efficiency of the microwave source and then to control the cooling based on the determined efficiency. The methods and the microwave heating apparatuses of the present invention are advantageous with respect to energy consumption.

CN 103 428 931 B teaches a control circuit of a microwave oven. The rotating speed of a fan is associated with the output power of a magnetron to improve the efficiency of the microwave oven. The control circuit of the microwave oven comprises a control portion, a frequency changer, the magnetron and the cooling fan. The control portion is used for outputting a pulse width modulated signal. The frequency changer is connected with the control portion so as to receive the pulse width modulated signal, the magnetron is connected with the frequency changer, and the cooling fan is connected with the control portion so as to receive the pulse width modulated signal.

CN 1 168 925 C discloses a microwave oven with a variable speed motor (FM) for driving its cooling fan. The speed of the motor is linked to the output power of the oven so that the fan rotates quicker for high power operation than for low power operation.

RU 2 770 871 C1 relates to equipment for cooling and freezing, in particular to a refrigeration and freezing device. The refrigerating and freezing device comprises a housing in which at least one storage compartment with a heating cavity is formed, and an electromagnetic heating device equipped with an electromagnetic generation module. In the upper part of the housing there is a groove for placement with an upwardly directed open part closed by a lid. Holes are formed in the lid for dissipating heat, configured to provide communication between the area for placement and the external environment in which the housing is located. The electromagnetic generation module is located in the placement area. In the area for placement, a fan is additionally installed to dissipate heat from the electromagnetic generation module

CN 209 897 305 U provides a heating device and a refrigerator with the same. The heating device comprises a cylinder provided with a pick-and-place opening, a door body used for opening and closing the pick-and-place opening, an electromagnetic generation module used for generating electromagnetic wave signals and a radiation antenna. The radiation antenna is arranged to be electrically connected with the electromagnetic generation module so as to generate electromagnetic waves with corresponding frequencies according to the electromagnetic wave signals. The heating device further comprises a signal processing, measuring and controlling circuit for measuring and controlling electromagnetic wave signals. And the signal processing and measurement and control circuit is electrically connected with the electromagnetic generation module and is arranged at the rear lower part in the cylinder body, so that the cylinder body has a larger storage space, and the circuit can be prevented from being damaged due to over-high food when the storage drawer is used for containing the food.

However, an electromagnetic wave generation system of the heating unit may generate more heat in a working process, which not only causes temperature fluctuation of a storage compartment and influences the preservation quality of food materials in the storage compartment, but also can reduce the working efficiency of the electromagnetic wave generation system. The service life of an electric device may be shortened seriously if the heating unit is kept in a high-temperature state for a long time.

### BRIEF DESCRIPTION OF THE INVENTION

An object of a first aspect of the present disclosure is to overcome at least one technical drawback in the prior art and to provide a control method for an electromagnetic wave heating unit.

A further object of the first aspect of the present disclosure is to reduce energy consumption.

An object of a second aspect of the present disclosure is to provide a heating unit.

An object of a third aspect of the present disclosure is to provide a refrigerating and freezing apparatus having the heating unit.

A further object of the third aspect of the present disclosure is to improve the cooling efficiency of an electromagnetic wave generation system.

According to the invention, as defined in claim 1, provided is a control method for a heating unit disposed within a refrigerating and freezing apparatus, the heating unit includes a cylinder configured to contain an item to be treated, and an electromagnetic wave generation system of which at least one part is disposed in the cylinder or accessed into the cylinder, the electromagnetic wave generation system including an electromagnetic wave generation module configured to generate an electromagnetic wave signal and a cooling fan configured to cool the electromagnetic wave generation module, wherein the control method includes:
acquiring a forward power signal output from the electromagnetic wave generation module and a reverse power signal returned to the electromagnetic wave generation module;
calculating an electromagnetic wave absorption rate of the item to be treated according to the forward power signal and the reverse power signal; and
adjusting a rotation speed of the cooling fan according to a power value of the forward power signal, and the electromagnetic wave absorption rate, the step of adjusting a rotation speed of the cooling fan according to a power value of the forward power signal, and the electromagnetic wave absorption rate includes:
   matching with the rotation speed of the cooling fan on the basis of a preset rotation speed correspondence relation according to the power value of the forward power signal, and the electromagnetic wave absorption rate, wherein
   the rotation speed correspondence relation records rotation speeds corresponding to power values in different ranges and electromagnetic wave absorption rates in different ranges; and
   under the condition that the power values of the forward power signal are the same, the rotation speed of the cooling fan is in negative correlation with an average value of the electromagnetic wave absorption rates in different ranges; and under the condition that the electromagnetic wave absorption rates are the same, the rotation speed of the cooling fan is in positive correlation with an average value of the power values in different ranges.

Optionally, the electromagnetic wave generation module includes a frequency source, a power amplifier and a processing unit; and the control method further includes:
acquiring a temperature of the processing unit; and
controlling the frequency source and the power amplifier to stop working if the temperature of the processing unit is greater than or equal to a preset temperature threshold.

Optionally, after the step of controlling the frequency source and the power amplifier to stop working, the control method further includes:
controlling the cooling fan to work at a rated rotation speed for a first preset time, and controlling the cooling fan to stop working after the first preset time. The claimed subject-matter is defined by the claims.

The above and other objects, advantages and features of the present disclosure will become more apparent to those skilled in the art from the following detailed description of specific embodiments thereof taken in conjunction with the accompanying drawings.

### BRIEF DESCRIPTION OF THE DRAWINGS

Some specific embodiments of the present disclosure will be described in detail hereinafter by way of example and not by way of limitation with reference to the accompanying drawings. The same reference numerals in the drawings identify the same or similar elements or parts. Those skilled in the art will appreciate that the drawings are not necessarily drawn to scale. In the drawings:
Fig. 1 is a schematic exploded view of a refrigerating and freezing apparatus according to an embodiment of the present disclosure;
Fig. 2 is a schematic structural view of a heating unit according to an embodiment of the present disclosure;
Fig. 3 is a schematic structural view of a controller in Fig. 2;
Fig. 4 is a schematic structural view of an electromagnetic wave generation module in Fig. 2;
Fig. 5 is a schematic partial cross-sectional view of the refrigerating and freezing apparatus shown in Fig. 1;
Fig. 6 is a schematic top view of an air outlet area in Fig. 5;
Fig. 7 is a schematic flow chart of a control method for a heating unit according to an embodiment of the present disclosure; and
Fig. 8 is a detailed flow chart of the control method for the heating unit according to an embodiment of the present disclosure.

### DETAILED DESCRIPTION

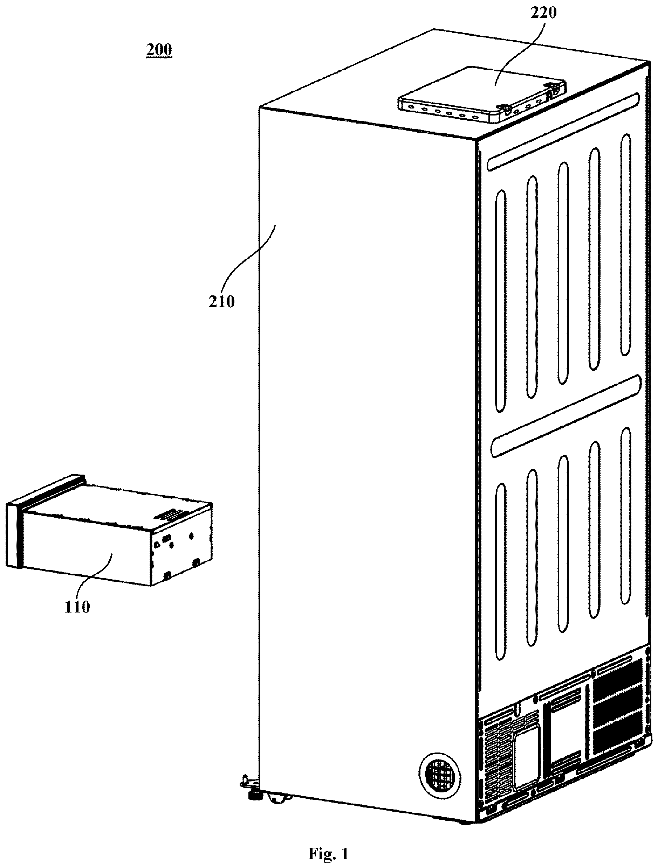

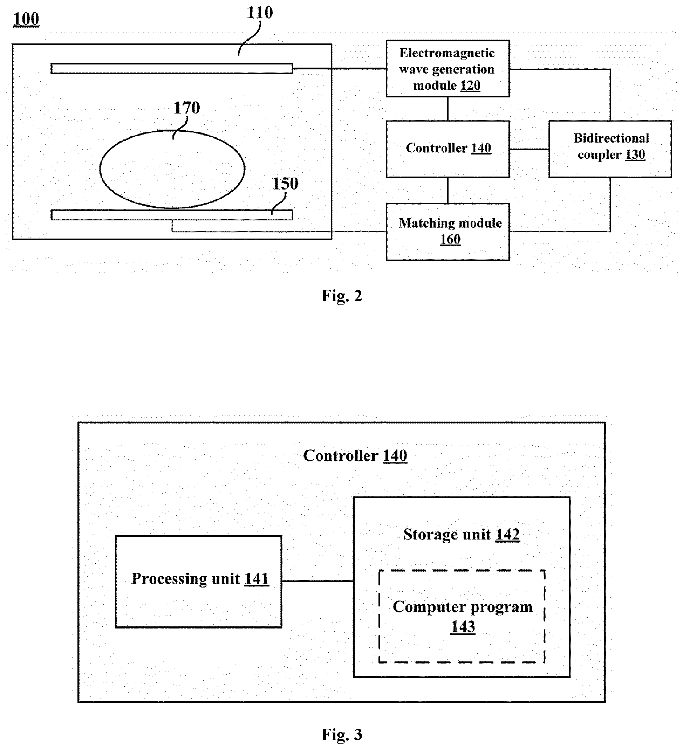

Fig. 1 is a schematic exploded view of a refrigerating and freezing apparatus 200 according to an embodiment of the present disclosure. Fig. 2 is a schematic structural view of a heating unit 100 according to an embodiment of the present disclosure. Referring to Fig. 1 and Fig. 2, the refrigerating and freezing apparatus 200 may include a cabinet 210 defining at least one storage compartment, at least one door configured to open and close the at least one storage compartment, a heating unit 100 and a controller. In the present disclosure, the refrigerating and freezing apparatus 200 may be an apparatus with a refrigerating or freezing function such as a refrigerator, a freezer, a cooler, a wine cabinet and so on.

The cabinet 210 may include a liner defining at least one storage compartment, an outer tank and a heat insulating layer disposed between the liner and the outer tank.

The heating unit 100 may include a cylinder 110 disposed in one storage compartment of the cabinet 210, a door and an electromagnetic wave generation system.

Specifically, the cylinder 110 may define a heating chamber configured to contain an item to be treated 170, and a pick-and-place opening may be formed in the front wall of the heating chamber and is configured to pick and place the item to be treated 170.

The door may be mounted with the cylinder 110 together by an appropriate method, such as connection by a slide track and connection in a hinged manner, and is configured to open and close the pick-and-place opening.

At least one part of the electromagnetic wave generation system may be disposed in the cylinder 110 or accessed into the cylinder 110 to generate an electromagnetic wave in the cylinder 110 to heat the item to be heated 170.

The cylinder 110 and the door may be respectively provided with electromagnetic shielding features, so that the door is in conductive connection with the cylinder 110 when the door is closed to prevent electromagnetic leakage.

Fig. 3 is a schematic structural view of a controller in Fig. 2. Referring to Fig. 3, the controller 140 may include a processing unit 141 and a storage unit 142. A computer program 143 is stored in the storage unit 142. The computer program 143 is configured to implement the control method according to an embodiment of the present disclosure when the computer program is executed by the processing unit 141.

In some embodiments, the electromagnetic wave generation system may include an electromagnetic wave generation module 120, a power supply module 180, a radiating antenna 150, and a matching module 160.

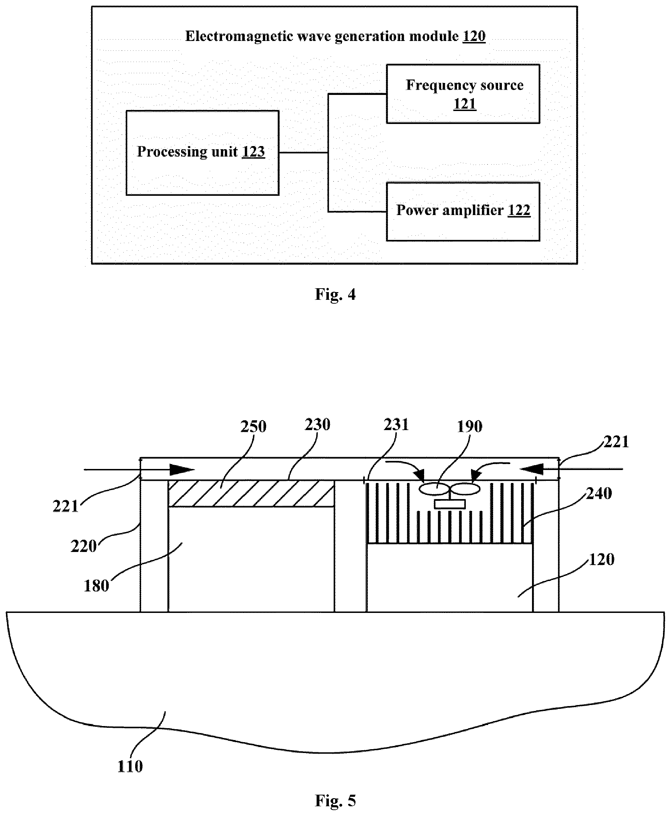

The electromagnetic wave generation module 120 may be configured to generate an electromagnetic wave signal. Fig. 4 is a schematic structural view of the electromagnetic wave generation module 120 in Fig. 2. Referring to Fig. 4, in some embodiments, the electromagnetic wave generation module 120 may include a frequency source 121, a power amplifier 122 and a processing unit 123.

The power supply module 180 may be disposed to be electrically connected to the electromagnetic wave generation module 120 so as to provide electric energy for the electromagnetic wave generation module 120, and then the electromagnetic wave generation module 120 generates the electromagnetic wave signal.

The radiating antenna 150 may be disposed in the cylinder 110 and is electrically connected to the electromagnetic wave generation module 120 so as to generate an electromagnetic wave with a corresponding frequency according to the electromagnetic wave signal to heat the item to be treated 170 in the cylinder 110.

The matching module 160 may be connected between the electromagnetic wave generation module 120 and the radiating antenna 150 in series, and is configured to adjust load impedance of the electromagnetic wave generation module 120 by means of adjusting self impedance to achieve load matching and improve heating efficiency.

In some further embodiments, the cylinder 110 may be made of metal to serve as a receiving pole of the radiating antenna 150. In the embodiments, the cylinder 110 itself is an electromagnetic shielding feature of the cylinder 110.

In other further embodiments, the electromagnetic wave generation system further includes a receiving polar plate which is opposite to the radiating antenna 150 and electrically connected to the electromagnetic wave generation module 120. In the embodiments, the inner wall of the cylinder 110 may be coated with a metal coating or attached with a metal net and the like as the electromagnetic shielding feature of the cylinder 110.

Fig. 5 is a schematic partial cross-sectional view of the refrigerating and freezing apparatus 200 as shown in Fig. 1. Referring to Fig. 5, particularly, the heating unit 100 may further include at least one cooling fan 190 configured to cool the electromagnetic wave generation module 120 and the power supply module 180. In the present disclosure, the electromagnetic wave generation module 120 and the power supply module 180 are cooled simultaneously by means of the cooling fan 190; thus, efficient cooling on the electromagnetic wave generation module 120 and the power supply module 180 may be realized, furthermore, occupied space is reduced, and the storage space of the refrigerating and freezing apparatus 200 is expanded.

In the present disclosure, the number of the cooling fans 190 may be one, two, or more than two. For the convenience of understanding of the present disclosure, the present disclosure will be described hereinafter by taking one cooling fan 190 as an example.

In some embodiments, the refrigerating and freezing apparatus 200 may further include cooling fins 240 thermally connected to the electromagnetic wave generation module 120 to increase the cooling area of the electromagnetic wave generation module 120, and then the cooling efficiency of the electromagnetic wave generation module 120 is improved.

The cooling fins 240 may include a plurality of rib plates perpendicular to the electromagnetic wave generation module 120, namely, each rib plate extends from the electromagnetic wave generation module 120 towards a direction away from the electromagnetic wave generation module 120, and is perpendicular to a surface where the rib plate is mounted.

The cooling fins 240 may further include a substrate integrated with the plurality of rib plates, and the substrate is configured to be thermally connected to the electromagnetic wave generation module 120.

The cooling fan 190 may be disposed on sides of the cooling fins 240 away from the electromagnetic wave generation module 120, and is disposed to blow out air flow towards the electromagnetic wave generation module 120. Namely, the electromagnetic wave generation module 120 is disposed downstream of the cooling fan 190 to reduce wind resistance, and the cooling efficiency of the electromagnetic wave generation module 120 is improved.

The extending direction of the plurality of rib plates may further be disposed to be perpendicular to a direction of the electromagnetic wave generation module 120 close to the power supply module 180, so as to reduce influences of heat generated by the electromagnetic wave generation module 120 on the power supply module 180.

At least one rib plate thermally connected to the middle of the electromagnetic wave generation module 120 is provided with an accommodating portion recessed towards a direction close to the electromagnetic wave generation module 120.

The cooling fan 190 may be disposed in the accommodating portion. A projection of the cooling fan 190 in an extending direction perpendicular to the plurality of rib plates is at least located in one of the rib plates, so as to further reduce influences of the heat on the power supply module 180 and further improve the cooling efficiency of the electromagnetic wave generation module 120.

The cooling fan 190 may be disposed to suck air flow via the power supply module 180 and prompt the air flow to be blown out towards the electromagnetic wave generation module 120, so as to improve the cooling efficiency of the electromagnetic wave generation module 120 and the power supply module 180 on the whole while the compactness of the structure is improved.

The refrigerating and freezing apparatus 200 may further include a housing 220 and a separator. The housing 220 may be configured to cover the electromagnetic wave generation module 120, the power supply module 180 and the cooling fan 190.

The separator may be disposed in the housing 220 and is disposed on a side of the cooling fan 190 away from the electromagnetic wave generation module 120, so as to separate a space in the housing 220 into an air inlet area and an air outlet area. The cooling fan 190 and the electromagnetic wave generation module 120 may be disposed in the air outlet area.

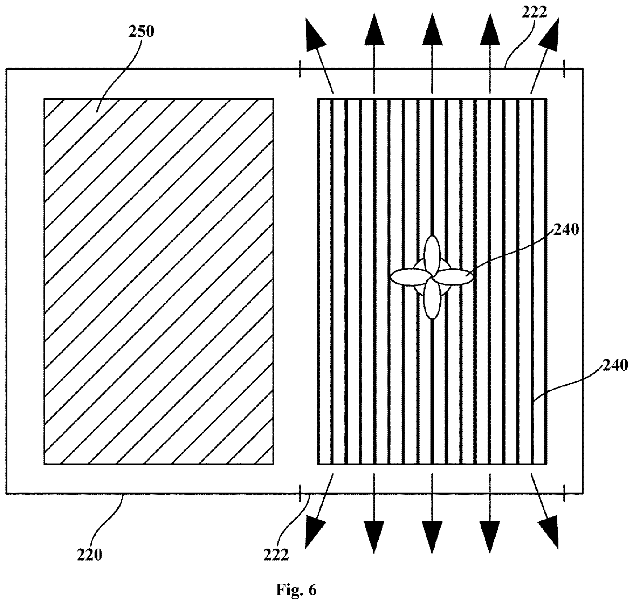

Fig. 6 is a schematic top view of the air outlet area in Fig. 5. Referring to Fig. 5 and Fig. 6, the air inlet area and the air outlet area are respectively provided with at least one air inlet 221 and at least one air outlet 222 in a circumferential direction of the cooling fan 190. At least one air vent 231 is formed in a position of the separator corresponding to the at least one cooling fan 190. Thus, the circumstances that water and dust enter the housing 220 via the air inlet 221 and the air outlet 222, and then the electromagnetic wave generation module 120 and the power supply module 180 are affected with damp and dust are avoided. Potential safety hazards are also avoided.

The flowing direction of air flow from the at least one air inlet 221 to the at least one air vent 231 respectively is perpendicular to the flowing direction of air flow from the at least one air vent 231 to each air outlet 222, so as to further reduce wind resistance and improve cooling efficiency.

The power supply module 180 may be disposed in the air outlet area, and is located on a side of the electromagnetic wave generation module 120 perpendicular to the flowing direction of air flow from the at least one air vent 231 to each air outlet 222, so that the cooling fan 190 cools the power supply module 180 and the electromagnetic wave generation module 120 respectively in processes of sucking air flow and blowing out the air flow. Influences of heat on the power supply module 180 are further reduced. The cooling efficiency is improved.

Further, the refrigerating and freezing apparatus 200 further includes a heat conducting material 250 thermally connected to the power supply module 180 and the separator, so as to improve the cooling efficiency of the power supply module 180.

The electromagnetic wave generation module 120, the power supply module 180, the cooling fan 190 and the housing 220 may be disposed on the outer side of the heating chamber, so as to reduce influences of heat generated by the electromagnetic wave generation module 120 and the power supply module 180 on the item to be treated 170 in the heating chamber. Further, the electromagnetic wave generation module 120 and the like may be disposed on the outer side of the heat insulating layer of the cabinet 210.

The cooling fan 190 may be disposed above the electromagnetic wave generation module 120. Namely, the electromagnetic wave generation module 120 may be disposed above the heat insulating layer, so as to improve the stability of the electromagnetic wave generation module 120 and the cooling fan 190.

The processing unit 141 may be configured to acquire a forward power signal output from the electromagnetic wave generation module 120 and a reverse power signal returned to the electromagnetic wave generation module 120 during working of the electromagnetic wave generation module 120, calculate an electromagnetic wave absorption rate of the item to be treated 170 according to the forward power signal and the reverse power signal, and adjust a rotation speed of the cooling fan 190 according to the power value of the forward power signal (namely the output power of the electromagnetic wave generation module 120) and the electromagnetic wave absorption rate.

A bidirectional coupler 130 may be connected between the electromagnetic wave generation module 120 and the radiating antenna 150 in series, to monitor the forward power signal output from the electromagnetic wave generation module 120 and the reverse power signal returned to the electromagnetic wave generation module 120.

In the present disclosure, the heating unit 100 adjusts, according to the power value of the forward power signal output from the electromagnetic wave generation module 120 and the electromagnetic wave absorption rate of the item to be treated 170, the rotation speed of the cooling fan 190 for cooling the electromagnetic wave generation module 120. Compared to a means of adjusting the rotation speed of the cooling fan 190 according to the temperature of the electromagnetic wave generation module 120, there is no need to arrange additional temperature sensing apparatuses, the heat generated by the electromagnetic wave generation module 120 can be reflected more precisely, unexpected energy waste and noise pollution are avoided while fully cooling the electromagnetic wave generation module 120, and user experiences are improved.

The processing unit 141 is configured to match with the rotation speed of the cooling fan 190 on the basis of a preset rotation speed correspondence relation according to the power value of the forward power signal and the electromagnetic wave absorption rate. The rotation speed correspondence relation records rotation speeds corresponding to power values in different ranges and electromagnetic wave absorption rates in different ranges.

Under the condition that the power values of the forward power signal are the same, the rotation speed of the cooling fan 190 is in negative correlation with an average value of the electromagnetic wave absorption rates in different ranges; and under the condition that the electromagnetic wave absorption rates are the same, the rotation speed of the cooling fan 190 is in positive correlation with an average value of the power values in different ranges, so that the electromagnetic wave generation module 120 is cooled efficiently in an energy-saving mode

The rotation speed correspondence relation may also be a formula which records different power values, electromagnetic wave absorption rates and rotation speeds.

The processing unit 141 may also be configured to acquire a temperature of the processing unit 123 of the electromagnetic wave generation module 120 in real time when the electromagnetic wave generation module 120 works, and control the frequency source 121 and the power amplifier 122 to stop working when the temperature of the processing unit 123 is greater than or equal to a preset temperature threshold, so as to guarantee the service life of the processing unit 123.

The processing unit 141 may further be configured to control the cooling fan 190 to work at a rated rotation speed for a first preset time and then stop working after controlling the frequency source 121 and the power amplifier 122 to stop working, so as to dissipate heat in the housing 220 quickly and avoid heat accumulation.

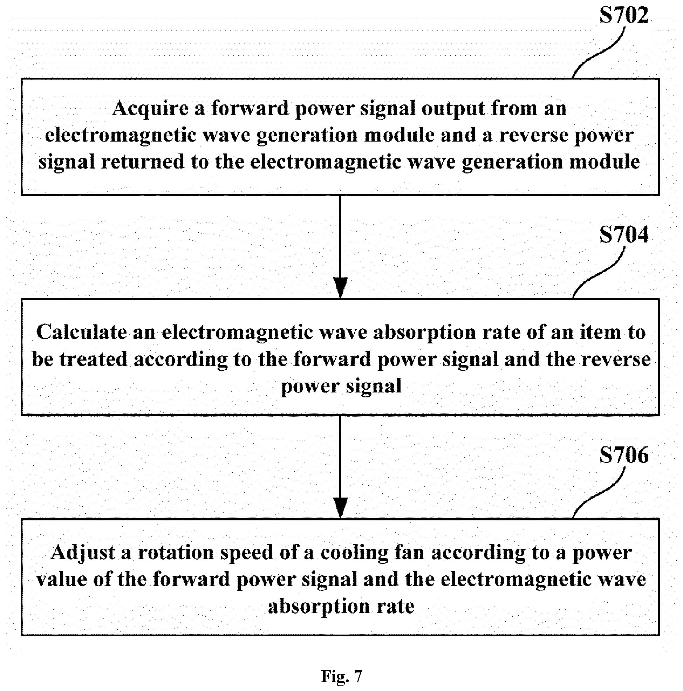

Fig. 7 is a schematic flow chart of a control method for the heating unit 100 according to an embodiment of the present disclosure. Referring to Fig. 7, the control method for the heating unit 100 executed by the controller 140 of any embodiment mentioned above may include the following steps:
Step S702: The forward power signal output from the electromagnetic wave generation module 120 and the reverse power signal returned to the electromagnetic wave generation module 120 are acquired.
Step S704: The electromagnetic wave absorption rate of the item to be treated 170 is calculated according to the forward power signal and the reverse power signal.
Step S706: The rotation speed of the cooling fan 190 is adjusted according to the power value of the forward power signal and the electromagnetic wave absorption rate.

In the control method of the present disclosure, the rotation speed of the cooling fan 190 for cooling the electromagnetic wave generation module 120 is adjusted according to the power value of the forward power signal output from the electromagnetic wave generation module 120 and the electromagnetic wave absorption rate of the item to be treated 170. Compared to the means of adjusting the rotation speed of the cooling fan 190 according to the temperature of the electromagnetic wave generation module 120, there is no need to dispose additional temperature sensing apparatuses, the heat generated by the electromagnetic wave generation module 120 can be reflected more precisely, and unexpected energy waste and noise pollution are avoided while fully cooling the electromagnetic wave generation module 120, and user experiences are improved.

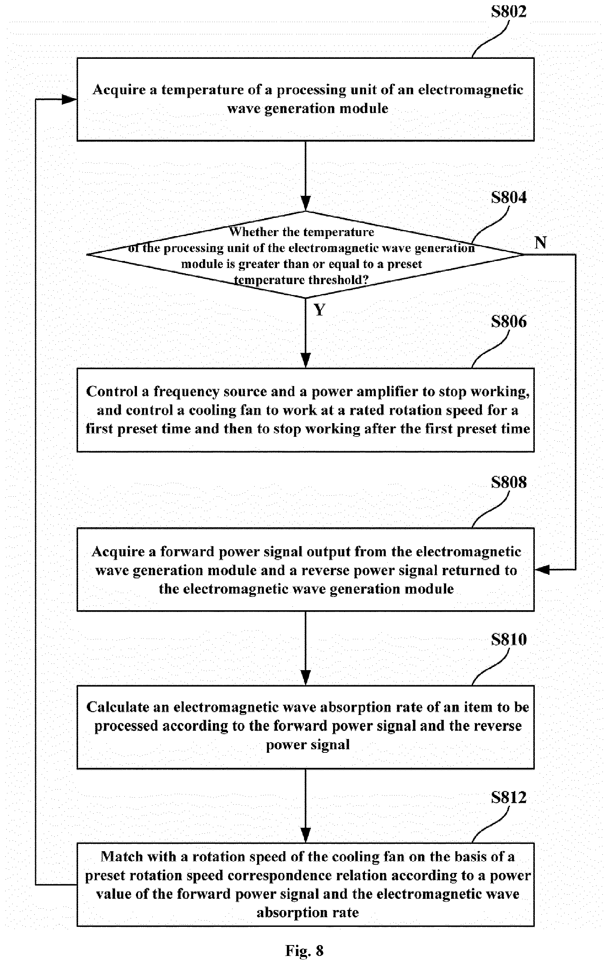

Fig. 8 is a detailed flow chart of the control method for the heating unit 100 according to an embodiment of the present disclosure. Referring to Fig. 8, the control method for the heating unit 100 of the present disclosure may include the following steps:
Step S802: The temperature of the processing unit of the electromagnetic wave generation module 120 is acquired.
Step S804: Whether the temperature of the processing unit 123 of the electromagnetic wave generation module 120 is greater than or equal to a preset temperature threshold is determined. If so, the step S806 is executed; and if not, the step S808 is executed.
Step S806: The frequency source 121 and the power amplifier 122 are controlled to stop working, the cooling fan 190 works at the rated rotation speed for the first preset time and then stops working after the first preset time, so as to guarantee the service life of the processing unit 123, and prevent heat from being accumulated in the housing 220.
Step S808: The forward power signal output from the electromagnetic wave generation module 120 and the reverse power signal returned to the electromagnetic wave generation module 120 are acquired. In this step, the forward power signal and the reverse power signal may be monitored and obtained by the bidirectional coupler 130 connected between the electromagnetic wave generation module 120 and the radiating antenna 150 in series. Then step S810 is executed.
Step S810: The electromagnetic wave absorption rate of the item to be treated 170 is calculated according to the forward power signal and the reverse power signal. Then step S812 is executed.
Step S812: The rotation speed of the cooling fan 190 is matched on the basis of the rotation speed correspondence relation according to the power value of the forward power signal and the electromagnetic wave absorption rate. Under the condition that the power values of the forward power signal are the same, the rotation speed of the cooling fan 190 is in negative correlation with the average value of the electromagnetic wave absorption rates in different ranges; and under the condition that the electromagnetic wave absorption rates are the same, the rotation speed of the cooling fan 190 is in positive correlation with the average value of the power values in different ranges, so that the electromagnetic wave generation module 120 is cooled efficiently in an energy-saving manner. The step S802 is executed again.

## Claims

1. A control method for a heating unit (100) disposed within a refrigerating and freezing apparatus, the heating unit (100) comprising a cylinder (110) configured to contain an item to be treated, and an electromagnetic wave generation system of which at least one part is disposed in the cylinder (110) or accessed into the cylinder (110), and the electromagnetic wave generation system comprising an electromagnetic wave generation module (120) configured to generate an electromagnetic wave signal and a cooling fan (190) configured to cool the electromagnetic wave generation module (120), wherein the control method comprises:
acquiring a forward power signal output from the electromagnetic wave generation module (120) and a reverse power signal returned to the electromagnetic wave generation module (120);
calculating an electromagnetic wave absorption rate of the item to be treated according to the forward power signal and the reverse power signal; and
adjusting a rotation speed of the cooling fan (190) according to a power value of the forward power signal, and the electromagnetic wave absorption rate,
wherein the step of adjusting a rotation speed of the cooling fan (190) according to a power value of the forward power signal, and the electromagnetic wave absorption rate comprises:
matching with the rotation speed of the cooling fan (190) on the basis of a preset rotation speed correspondence relation according to the power value of the forward power signal, and the electromagnetic wave absorption rate, wherein
the rotation speed correspondence relation records rotation speeds corresponding to power values in different ranges and electromagnetic wave absorption rates in different ranges; and
under the condition that the power values of the forward power signal are the same, the rotation speed of the cooling fan (190) is in negative correlation with an average value of the electromagnetic wave absorption rates in different ranges; and under the condition that the electromagnetic wave absorption rates are the same, the rotation speed of the cooling fan (190) is in positive correlation with an average value of the power values in different ranges.

2. The control method according to claim 1, wherein the electromagnetic wave generation module (120) comprises a frequency source (121), a power amplifier (122) and a processing unit (123); and the control method further comprises:
acquiring a temperature of the processing unit (123); and
controlling the frequency source (121) and the power amplifier (122) to stop working if the temperature of the processing unit (123) is greater than or equal to a preset temperature threshold.

3. The control method according to claim 2, wherein after the step of controlling the frequency source (121) and the power amplifier (122) to stop working, the control method further comprises:
controlling the cooling fan (190) to work at a rated rotation speed for a first preset time, and controlling the cooling fan (190) to stop working after the first preset time.

4. A refrigerating and freezing apparatus (200), comprising:
a cabinet (210), defining at least one storage compartment; and
a heating unit (100), comprising:
a cylinder (110), configured to contain an item to be treated;
an electromagnetic wave generation system, at least one part thereof being disposed in the cylinder (110) or accessed into the cylinder (110) to generate an electromagnetic wave in the cylinder (110) to heat the item to be treated, and the electromagnetic wave generation system comprising an electromagnetic wave generation module (120) configured to generate an electromagnetic wave signal and a cooling fan (190) configured to cool the electromagnetic wave generation module (120); and
a controller (140), configured to execute the control method according to any one of claims 1 to 3, wherein
the cylinder (110) is disposed in one of the at least one storage compartment, and the electromagnetic wave generation module (120) is disposed on an outer side of a heat insulating layer of the cabinet (210).

5. The refrigerating and freezing apparatus (200) according to claim 4, further comprising:
a housing (220), disposed to cover the electromagnetic wave generation module (120) and the cooling fan (190); and
a separator, disposed in the housing (220) and located on a side of the cooling fan (190) away from the electromagnetic wave generation module (120) to separate a space in the housing (220) into an air inlet area and an air outlet area, wherein
the cooling fan (190) and the electromagnetic wave generation module (120) are disposed in the air outlet area;
the air inlet area and the air outlet area are respectively provided with at least one air inlet (221) and at least one air outlet (222) in a circumferential direction of the cooling fan (190), and at least one air vent is formed in a position of the separator corresponding to the cooling fan (190); and
a flowing direction of air flow from the at least one air inlet (221) to the at least one air vent respectively is perpendicular to a flowing direction of air flow from the at least one air vent to each air outlet.

6. The refrigerating and freezing apparatus (200) according to claim 5, wherein the electromagnetic wave generation system further comprises:
a power supply module (180), configured to provide electric energy for the electromagnetic wave generation module (120), wherein
the power supply module (180) is disposed in the air outlet area, and located on a side of the electromagnetic wave generation module (120) perpendicular to the flowing direction of air flow from the at least one air vent to each air outlet; and
the power supply module (180) is provided with a heat conducting material, and the heat conducting material is disposed to be thermally connected to the separator.

7. The refrigerating and freezing apparatus (200) according to claim 4, wherein the electromagnetic wave generation system further comprises:
a radiating antenna (150), disposed in the cylinder (110), and electrically connected to the electromagnetic wave generation module (120) to radiate the electromagnetic wave in the cylinder (110); and
a bidirectional coupler, connected between the electromagnetic wave generation module (120) and the radiating antenna (150) in series, and configured to monitor the forward power signal and the reverse power signal, wherein
the cylinder (110) defines a heating chamber configured to contain the item to be treated; and
the electromagnetic wave generation module (120) is disposed on an outer side of the heating chamber.

## Patentansprüche

1. Steuerverfahren für eine Heizeinheit (100), die in einer Kühl- und Gefriervorrichtung angeordnet ist, wobei die Heizeinheit (100) einen Zylinder (110), der so konfiguriert ist, dass er einen zu behandelnden Gegenstand enthält, und ein System zur Erzeugung elektromagnetischer Wellen umfasst, von dem mindestens ein Teil in dem Zylinder (110) angeordnet ist oder in den Zylinder (110) hineingelangt, und wobei das System zur Erzeugung elektromagnetischer Wellen ein Modul (120) zur Erzeugung elektromagnetischer Wellen, das so konfiguriert ist, dass es ein elektromagnetisches Wellensignal erzeugt, und ein Kühlgebläse (190) umfasst, das so konfiguriert ist, dass es das Modul (120) zur Erzeugung elektromagnetischer Wellen kühlt, wobei das Steuerverfahren umfasst:
Erfassen eines Vorwärtsleistungssignals, das von dem Modul (120) zur Erzeugung elektromagnetischer Wellen ausgegeben wird, und eines Rückwärtsleistungssignals, das zu dem Modul (120) zur Erzeugung elektromagnetischer Wellen zurückkehrt;
Berechnen einer Absorptionsrate elektromagnetischer Wellen des zu behandelnden Gegenstands gemäß dem Vorwärtsleistungssignal und dem Rückwärtsleistungssignal; Und
Einstellen einer Drehzahl des Kühlgebläses (190) gemäß einem Leistungswert des Vorwärtsleistungssignals und der Absorptionsrate elektromagnetischer Wellen,
Wobei der Schritt des Einstellens einer Drehzahl des Kühlgebläses (190) gemäß einem Leistungswert des Vorwärtsleistungssignals und der Absorptionsrate umfasst:
Anpassen an die Drehzahl des Kühlgebläses (190) auf der Grundlage einer voreingestellten Drehzahl-Korrespondenzbeziehung gemäß dem Leistungswert des Vorwärtsleistungssignals und der Absorptionsrate der elektromagnetischen Wellen, wobei
die Drehzahl-Korrespondenzbeziehung Drehzahl aufzeichnet, die Leistungswerten in verschiedenen Bereichen und Absorptionsraten elektromagnetischer Wellen in verschiedenen Bereichen entsprechen; und
unter der Bedingung, dass die Leistungswerte des Vorwärtsleistungssignals gleich sind, die Drehzahl des Kühlgebläses (190) in negativer Korrelation mit einem Durchschnittswert der Absorptionsraten der elektromagnetischen Wellen in verschiedenen Bereichen steht; und unter der Bedingung, dass die Absorptionsraten der elektromagnetischen Wellen gleich sind, die Drehzahl des Kühlgebläses (190) in positiver Korrelation mit einem Durchschnittswert der Leistungswerte in verschiedenen Bereichen steht.

2. Steuerverfahren nach Anspruch 1, wobei das Modul (120) zur Erzeugung elektromagnetischer Wellen eine Frequenzquelle (121), einen Leistungsverstärker (122) und eine Verarbeitungseinheit (123) umfasst; und wobei das Steuerverfahren ferner umfasst:
Erfassen einer Temperatur der Verarbeitungseinheit (123); und
Steuern der Frequenzquelle (121) und des Leistungsverstärkers (122), um den Betrieb zu stoppen, wenn die Temperatur der Verarbeitungseinheit (123) größer oder gleich einem voreingestellten Temperaturschwellenwert ist.

3. Steuerverfahren nach Anspruch 2, wobei das Steuerverfahren nach dem Schritt des Steuerns der Frequenzquelle (121) und des Leistungsverstärkers (122), um den Betrieb zu stoppen, weiterhin umfasst:
Steuern des Kühlgebläses (190), damit es für eine erste voreingestellte Zeit mit einer Nenndrehzahl arbeitet, und Steuern des Kühlgebläses (190), damit es nach der ersten voreingestellten Zeit nicht mehr arbeitet.

4. Kühl- und Gefriervorrichtung (200), umfassend:
einen Schrank (210), der mindestens ein Lagerfach definiert; und
eine Heizeinheit (100), umfassend:
einen Zylinder (110), der so konfiguriert ist, dass er einen zu behandelnden Gegenstand enthält;
ein System zur Erzeugung elektromagnetischer Wellen, wobei mindestens ein Teil davon in dem Zylinder (110) angeordnet ist oder in den Zylinder (110) hineingelangt, um eine elektromagnetische Welle in dem Zylinder (110) zu erzeugen, um den zu behandelnden Gegenstand zu erhitzen, und wobei das System zur Erzeugung elektromagnetischer Wellen ein Modul (120) zur Erzeugung elektromagnetischer Wellen, das so konfiguriert ist, dass es ein elektromagnetisches Wellensignal erzeugt, und ein Kühlgebläse (190) umfasst, das so konfiguriert ist, dass es das Modul (120) zur Erzeugung elektromagnetischer Wellen kühlt, und
eine Steuerung (140), der so konfiguriert ist, dass er das Steuerverfahren nach einem der Ansprüche 1 bis 3 ausführt, wobei
der Zylinder (110) in einem der mindestens einen Lagerfächer angeordnet ist und das Modul (120) zur Erzeugung elektromagnetischer Wellen an einer Außenseite einer wärmeisolierenden Schicht des Schranks (210) angeordnet ist.

5. Kühl- und Gefriervorrichtung (200) nach Anspruch 4, ferner umfassend:
ein Gehäuse (220), das so angeordnet ist, dass es das Modul (120) zur Erzeugung elektromagnetischer Wellen und das Kühlgebläse (190) abdeckt; und
einen Separator, der in dem Gehäuse (220) angeordnet ist und sich auf einer von dem Modul (120) zur Erzeugung elektromagnetischer Wellen entfernten Seite des Kühlgebläses (190) befindet, um einen Raum in dem Gehäuse (220) in einen Lufteinlassbereich und einen Luftauslassbereich zu unterteilen, wobei
das Kühlgebläse (190) und das Modul zur Erzeugung elektromagnetischer Wellen (120) im Luftauslassbereich angeordnet sind;
der Lufteinlassbereich und der Luftauslassbereich jeweils mit mindestens einem Lufteinlass (221) und mindestens einem Luftauslass (222) in einer Umfangsrichtung des Kühlgebläses (190) versehen sind und mindestens eine Entlüftungsöffnung an einer dem Kühlgebläse (190) entsprechenden Position des Separators ausgebildet ist; und
eine Strömungsrichtung des Luftstroms von dem mindestens einen Lufteinlass (221) zu der mindestens einen Entlüftungsöffnung jeweils rechtwinklig zu einer Strömungsrichtung des Luftstroms von der mindestens einen Entlüftungsöffnung zu jedem Luftauslass ist.

6. Kühl- und Gefriervorrichtung (200) nach Anspruch 5, wobei das System zur Erzeugung elektromagnetischer Wellen weiterhin umfasst:
ein Stromversorgungsmodul (180), das so konfiguriert ist, dass es elektrische Energie für das Modul zur Erzeugung elektromagnetischer Wellen (120) bereitstellt, wobei
das Stromversorgungsmodul (180) in dem Luftauslassbereich angeordnet ist und sich auf einer Seite des Moduls (120) zur Erzeugung elektromagnetischer Wellen befindet, die senkrecht zur Strömungsrichtung des Luftstroms von der mindestens einen Entlüftungsöffnung zu jedem Luftauslass verläuft; und
das Stromversorgungsmodul (180) mit einem wärmeleitenden Material versehen ist, und das wärmeleitende Material so angeordnet ist, dass es thermisch mit dem Separator verbunden ist.

7. Kühl- und Gefriervorrichtung (200) nach Anspruch 4, wobei das System zur Erzeugung elektromagnetischer Wellen weiterhin umfasst:
eine Strahlungsantenne (150), die im Zylinder (110) angeordnet und elektrisch mit dem Modul (120) zur Erzeugung elektromagnetischer Wellen verbunden ist, um die elektromagnetische Welle im Zylinder (110) abzustrahlen; Und
einen bidirektionalen Koppler, der zwischen dem Modul (120) zur Erzeugung elektromagnetischer Wellen und der Strahlungsantenne (150) in Reihe geschaltet ist und so konfiguriert ist, dass er das Vorwärtsleistungssignal und das Rückwärtsleistungssignal überwacht, wobei
der Zylinder (110) eine Heizkammer definiert, die so konfiguriert ist, dass sie den zu behandelnden Gegenstand enthält; und
das Modul (120) zur Erzeugung elektromagnetischer Wellen an einer Außenseite der Heizkammer angeordnet ist.

## Revendications

1. Méthode de contrôle pour un dispositif de chauffage (100) disposé dans un appareil de réfrigération et de congélation, le dispositif de chauffage (100) comprenant un cylindre (110) configuré pour contenir un élément à traiter, et un système de génération d'ondes électromagnétiques dont au moins une partie est disposée dans le cylindre (110) ou accessible dans le cylindre (110), et le système de génération d'ondes électromagnétiques comprenant un module de génération d'ondes électromagnétiques (120) configuré pour générer un signal d'onde électromagnétique et un ventilateur de refroidissement (190) configuré pour refroidir le module de génération d'ondes électromagnétiques (120), dans lequel la méthode de contrôle comprend :
acquisition d'un signal de puissance directe sortant du module de génération d'ondes électromagnétiques (120) et d'un signal de puissance inverse retourné au module de génération d'ondes électromagnétiques (120) ;
calcul d'un taux d'absorption d'ondes électromagnétiques de l'élément à traiter en fonction du signal de puissance directe et du signal de puissance inverse ; et
réglage d'une vitesse de rotation du ventilateur de refroidissement (190) en fonction d'une valeur de puissance du signal de puissance directe et du taux d'absorption d'ondes électromagnétiques,
dans lequel l'étape de réglage d'une vitesse de rotation du ventilateur de refroidissement (190) en fonction d'une valeur de puissance du signal de puissance directe et du taux d'absorption d'ondes électromagnétiques comprend :
correspondance de la vitesse de rotation du ventilateur de refroidissement (190) sur la base d'une relation de correspondance de vitesse de rotation prédéfinie en fonction de la valeur de puissance du signal de puissance directe et du taux d'absorption d'ondes électromagnétiques, dans lequel
la relation de correspondance de vitesse de rotation enregistre des vitesses de rotation correspondant à des valeurs de puissance dans différentes plages et des taux d'absorption d'ondes électromagnétiques dans différentes plages ; et
dans la condition où les valeurs de puissance du signal de puissance directe sont les mêmes, la vitesse de rotation du ventilateur de refroidissement (190) est en corrélation négative avec une valeur moyenne des taux d'absorption d'ondes électromagnétiques dans différentes plages ; et dans la condition où les taux d'absorption d'ondes électromagnétiques sont les mêmes, la vitesse de rotation du ventilateur de refroidissement (190) est en corrélation positive avec une valeur moyenne des valeurs de puissance dans différentes plages.

2. Méthode de contrôle selon la revendication 1, dans laquelle le module de génération d'ondes électromagnétiques (120) comprend une source de fréquence (121), un amplificateur de puissance (122) et une unité de traitement (123) ; et la méthode de contrôle comprend en outre :
acquisition d'une température de l'unité de traitement (123) ; et
commande de la source de fréquence (121) et de l'amplificateur de puissance (122) pour arrêter de fonctionner si la température de l'unité de traitement (123) est supérieure ou égale à un seuil de température prédéfini.

3. La méthode de contrôle selon la revendication 2, dans laquelle après l'étape de commande de la source de fréquence (121) et de l'amplificateur de puissance (122) pour arrêter de fonctionner, la méthode de contrôle comprend en outre :
la commande du ventilateur de refroidissement (190) pour fonctionner à une vitesse de rotation nominale pendant un premier temps prédéfini, et la commande du ventilateur de refroidissement (190) pour arrêter de fonctionner après le premier temps prédéfini.

4. Un appareil de réfrigération et de congélation (200), comprenant :
une armoire (210) définissant au moins un compartiment de stockage ; et
un dispositif de chauffage (100), comprenant :
un cylindre (110) configuré pour contenir un élément à traiter ;
un système de génération d'ondes électromagnétiques, dont au moins une partie est disposée dans le cylindre (110) ou accessible dans le cylindre (110) pour générer une onde électromagnétique dans le cylindre (110) pour chauffer l'élément à traiter, et le système de génération d'ondes électromagnétiques comprenant un module de génération d'ondes électromagnétiques (120) configuré pour générer un signal d'onde électromagnétique et un ventilateur de refroidissement (190) configuré pour refroidir le module de génération d'ondes électromagnétiques (120) ; et
un contrôleur (140) configuré pour exécuter la méthode de contrôle selon l'une quelconque des revendications 1 à 3, dans lequel
le cylindre (110) est disposé dans l'un des au moins un compartiment de stockage, et le module de génération d'ondes électromagnétiques (120) est disposé sur un côté extérieur d'une couche isolante thermique de l'armoire (210).

5. L'appareil de réfrigération et de congélation (200) selon la revendication 4, comprenant en outre :
un boîtier (220) disposé pour couvrir le module de génération d'ondes électromagnétiques (120) et le ventilateur de refroidissement (190) ; et
un séparateur disposé dans le boîtier (220) et situé sur un côté du ventilateur de refroidissement (190) éloigné du module de génération d'ondes électromagnétiques (120) pour séparer un espace dans le boîtier (220) en une zone d'entrée d'air et une zone de sortie d'air, dans lequel
le ventilateur de refroidissement (190) et le module de génération d'ondes électromagnétiques (120) sont disposés dans la zone de sortie d'air ;
la zone d'entrée d'air et la zone de sortie d'air sont respectivement pourvues d'au moins une entrée d'air (221) et d'au moins une sortie d'air (222) dans une direction circonférentielle du ventilateur de refroidissement (190), et au moins un évent est formé dans une position du séparateur correspondant au ventilateur de refroidissement (190) ; et
une direction d'écoulement de l'air à partir de la ou des entrées d'air (221) vers le ou les évents est perpendiculaire à une direction d'écoulement de l'air à partir du ou des évents vers chaque sortie d'air.

6. L'appareil de réfrigération et de congélation (200) selon la revendication 5, dans lequel le système de génération d'ondes électromagnétiques comprend en outre :
un module d'alimentation électrique (180) configuré pour fournir de l'énergie électrique au module de génération d'ondes électromagnétiques (120), dans lequel
le module d'alimentation électrique (180) est disposé dans la zone de sortie d'air et situé sur un côté du module de génération d'ondes électromagnétiques (120) perpendiculairement à la direction d'écoulement de l'air à partir du ou des évents vers chaque sortie d'air ; et
le module d'alimentation électrique (180) est pourvu d'un matériau conducteur de chaleur, et le matériau conducteur de chaleur est disposé pour être en contact thermique avec le séparateur.

7. L'appareil de réfrigération et de congélation (200) selon la revendication 4, dans lequel le système de génération d'ondes électromagnétiques comprend en outre :
une antenne rayonnante (150) disposée dans le cylindre (110) et connectée électriquement au module de génération d'ondes électromagnétiques (120) pour rayonner l'onde électromagnétique dans le cylindre (110) ; et
un coupleur bidirectionnel connecté en série entre le module de génération d'ondes électromagnétiques (120) et l'antenne rayonnante (150) et configuré pour surveiller le signal de puissance directe et le signal de puissance inverse, dans lequel
le cylindre (110) définit une chambre de chauffage configurée pour contenir l'élément à traiter ; et
le module de génération d'ondes électromagnétiques (120) est disposé sur un côté extérieur de la chambre de chauffage.
